# EUROPEAN PATENT APPLICATION

(11) **EP 3 090 854 A1**
(43) Date of publication of application: **09.11.2016**
(21) Application number: 15166811.8
(22) Date of filing: 07.05.2015
(51) Int. Cl.: B29C 45/14, D06F 39/00, H05K 3/28, H05K 5/00, H05K 5/06, B29C 70/72, H05K 1/11

(54) **HOUSEHOLD APPLIANCE WITH A CONTROL CIRCUIT BOARD**

(71) Applicant: Electrolux Appliances Aktiebolag, 105 45 Stockholm (SE)
(72) Inventor: De Pellegrin, Andrea, 33080 Porcia (PN) (IT); Armonia, Massimiliano, 33080 Porcia (PN) (IT); Castellarin, Valter, 33080 Porcia (PN) (IT)
(74) Representative: Electrolux Group Patents

(57) **Abstract**

Household appliance (2) with at least one control circuit board (150) , said control circuit board (150) comprising at least one contact (180, 184) provided at the periphery (182) of said board (150), and further comprising a protective layer (220, 226), said layer (220, 226) covering said board (150) at least partially, wherein a separating element (52) is provided on said board (150), said separating element (52) being configured and positioned to separate said at least one contact (180, 184) from said protective layer (220, 226).

## Description

### Field of the invention

The present invention generally relates to a household appliance, especially laundry treatment appliance such as a washing machine, dryer or combined washer and dryer, both for domestic and professional use. More particularly, the present invention relates to a household appliance comprising at least one control circuit board.

### Background of the invention

Control circuit boards are used usually for controlling and operating a household appliance. The user can, in case of a laundry treatment machine, typically select a desired laundry treatment program and/or select or input specific parameters related to the treatment routine, which are then used to operate the various components of the laundry treatment appliance such as inflow or outflow of water, drum rotation etc. Moreover, the user can check the operation of the appliance through display means, such as displays, lights, symbols, etc.

In order to provide this functionality, the control circuit board has to be connected to various electrical components of the appliance and to this end provides electrical contacts which for convenient access and cost reasons are typically located at the periphery of the board. Laundry treatment appliances such as washing machines, dryers, or combined washers and dryers during operation can receive / contain water and / or moisture internally, and said water / moisture may spread into regions containing movable components or electrically operating parts, resulting in risks of short circuits, damage of the components and safety hazards; additionally dust, fluff and / or bugs can enter on the appliances causing the above mentioned problems.

It is therefore advantageous to protect these components from ambient water, or other harmful solid bodies such as dust, fluff, bugs etc. Especially the control circuit board, which comprises the main logic and intelligence for operating the appliance, should be protected from water or contaminating material, since short circuits can easily destroy the overall functionality of the appliance, leading to high repair costs. The WO 2013/064285 A1 discloses an electronic module for a vehicle with a interconnect device with at least one connection element. The interconnect device is arranged in a bowl-type casing and potted with covered with pottant, with the connection element protruding out of the pottant; said pottant material allows the protection of the functional components provided on said electronic module from the external ambient, especially from foreign liquids.

Disadvantages of common solutions are the strong constraints on the layout of the protected boards and the costs for constructing dedicated covers for covering the circuit board; furthermore, the common solutions doesn't allow the use of cheap contacts, provided of the periphery of the board, completely insulated from the protecting material.

### Summary of the invention

The aim of the present invention is therefore to provide a solution without the aforementioned disadvantages.

A further aim is to provide a household appliance with at least one control circuit board comprising peripheral contacts that is reliable protected against moist and dirt.

A further aim is to reduce the production costs of such a control circuit board.

A further aim is to provide a method for assembling a household appliance with a control circuit board in an easy way.

### Disclosure of the invention

According to a first aspect, the invention relates to a household appliance with at least one control circuit board, the control circuit board comprising at least one contact provided at the periphery of the board, and further comprising a protective layer, the layer covering the board at least partially, wherein a separating element is provided on the board, the separating element being configured and positioned to separate the at least one contact from the protective layer.

Preferred embodiments of the invention are described in relation to the dependent claims and the description of the enclosed drawings.

The invention is based on the consideration that modern demands on control circuits boards which are essential components for the operation of the household appliance involve high quality, high reliability and an excellent safety performance. To this end, the board should be protected against any kind of foreign dangerous liquids / bodies that are prone to reduce its functionality, such as water, dust, fluff, bugs etc. which can enter / form inside a household appliance during regular and continuous operation over a certain time. This protection can be achieved effectively by a protection layer covering the board, thus preventing the contact of these foreign liquids / bodies with functional components / circuit tracks provided on said board, and consequently preventing the affecting of the correct working and the life of household appliance. Such a protective layer can be provided by pouring an appropriate material on the board.

Applicant has recognized that the board with its electric components and its edge with peripheral contacts require different protection levels. While the electronic components should be covered and thus be protected, peripheral contacts should be accessible for connectors. The simultaneous requirements to put a protective layer on the board and to leave the contacts accessible has in the past led to complicated jig designs, expensive bowl-type casing, and strong constraints on the design of the board.

Applicant has found that these demands or requirements can be met simultaneously for edge contacts by providing a separating element on the board which separates the contacts from the protective layer and which thereby defines and realizes a barrier between them. Such a separating element can be mounted on the board before a potting process and therefore in the first place prevent the protective layer to cover or to reach the region of the contacts.

The respective contact is preferably directly provided on the board. The separating element is advantageously at least partially arranged between the respective contact and the protective layer, allowing no contact of respective contact and protective layer.

The separating element is preferably built as a frame which encompasses the board at its periphery at least at one side. Preferably, the frame encompasses the board at its periphery from both sides, i.e. a top and bottom side. The frame can encompass one or several adjacent edges of the board.

With the separating element being configured and positioned to separate the at least one contact from the protective layer, it is preferably arranged in between the protective layer and the respective contact, thereby hindering the contact between the protective layer and the contact. In this way it constitutes a material barrier between the layer and the contact.

The household appliance is preferably a terms laundry treatment appliance. The terms laundry treatment appliance or laundry machine or laundry treatment device includes washing machines as such but also combined washing/drying machines that can incorporate both functionalities. Also the terms laundry washing machine and washing machine are used interchangeably. The laundry washing machine can, for instance, be designed as a front-loading laundry washing machine. Alternatively, the appliance can be a dryer or a refrigerating appliance.

Preferably the control circuit board comprises a carrier member where functional components and / or circuit tracks are provided, wherein the at least one contact is directly provided at the periphery of the carrier member and the protective layer covers the carrier member at least partially, and wherein the separating element is provided on the carrier member, configured and positioned to separate the at least one contact from the protective layer.

Preferably the protective layer covers the carrier member partially, and the separating element is provided on the portion of the carrier member not covered by the protective layer, the separating element being configured and positioned to separate the at least one contact from the protective layer.

Preferable the protective layer covers the carrier member at least on the portion where functional components are placed.

The separating element in its mounted position is preferably in contact with the protective layer. This configuration allows a protection of the board with the protective layer right up to the separating element, leaving no gaps or leeway for dust, fluff or water etc. to get in contact with the board.

In a preferred embodiment, the separating element comprises an upper part and a lower part, these parts being connected by at least one connection element by which these parts are distanced by a distance essentially corresponding to the thickness of the control circuit board / carrier member. Preferably, for an enhanced stability and advantageous distribution of forces, a plurality of connection elements is used.

Preferably, the separation element comprises at least one element configured to be embedded in or inserted into the protective layer. This design allows an enhanced stability and fixation between board and separation element due to a frictionally engaged connection of the protective layer with the frame and of the protective layer with the board.

Advantageously, the board / carrier member comprises at least one opening, and the separation element comprises at least one opening which in a mounted position of the separation element is concentric with the opening on the board / carrier member. This embodiment allows achieving a precise placement of the separation element on the circuit board due to a pin which is provided on a jig. When the board and the separation element are positioned in a jig, the pin can be lead through both concentric openings or holes and thereby keep these two components aligned during the procedure in which the protective layer is provided on the board.

In a preferred embodiment, the separation element comprises connection means, these connections means being configured to allow the assembly of at least one connector. Connectors are preferably used to electrically connect other electric components of the household appliance to the control circuit board, allowing their operation and control.

Preferably the board / carrier member comprises an upper side and a lower side, whereby on each of these sides, at least one contact is preferably provided, and whereby the protective layer is preferably provided on both sides, and whereby the separating element preferably separates the protective layer and the respective contact on both sides.

Advantageously, the separation element has an L-shape, comprising a first part and a second part which is inclined with respect to the first part. In a preferred embodiment, this inclination is perpendicular.

In a further preferred embodiment, the board has two adjacent sides inclined to each other by an inclination, and whereby the inclination of first and second part of the separation element is essentially identical to the former inclination, in which way the separation element encompasses or wraps these two adjacent sides. Advantageously, on these each sides the board or carrier member comprises contacts separated from the protective layer by the separation element. In this way, contacts on two adjacent sides can be separated from the protective layer by the separation element.

The protective layer is preferably essentially made of a protective material that changes its state. The possible states which the protective material can assume comprise preferably the states solid and liquid. Preferably, the protective material changes its state from a liquid to a solid state.

Advantageously, the protective material is in a liquid state and in a solid state after the polymerization. This property of the protective material allows covering the desired parts of the board while the protective material is in a liquid state. After polymerization, the protective material is in a solid state and acts as a protective layer for the board and the components covered by the protective material.

The protective material can be a mixture of two components with different viscosities, allowing to obtain a protective material with a desired viscosity in between the viscosities of the two components.

In a preferred embodiment, the protective material is essentially silicon, which possesses the described preferred properties.

In other preferred embodiments, the change from a liquid state to a solid state of the protective material can take place as a function of at least one physical parameter such as the temperature.

In a second aspect, the invention relates to a method for assembling a household appliance, the household appliance comprising at least one control circuit board comprising at least one contact provided at the periphery of the board, the method comprising the steps of:
- mounting a separation element on the board;
- inserting the assembly of the board and the separating element in a jig;
- casting the protective material in its liquid state on the jig, covering at least a portion of the board, said at least a portion being separated from the at least one contact by the separation element;
- extracting the assembly with the protective layer from the jig after the protective layer has become solid;
- mounting the assembly in the household appliance.

The invention also relates to a method for assembling a household appliance, the household appliance comprising a control circuit board, the method comprising the steps of:
- inserting the board into a jig;
- casting said protective material in its liquid state into the jig, covering at least a portion of said board;
- extracting the board from the jig after said protective layer has become solid;
- mounting a separation element on the board such that in its mounted position the separation element spatially separates the at least one contact from the protective layer;
- mounting the assembly in the household appliance.

Preferably, said control circuit board comprises a carrier member where functional components and / or circuit tracks are provided, wherein said at least a contact is directly provided at the periphery of the carrier member, said method comprising the steps of:
- mounting a separation element on said carrier member;
- inserting the assembly of said carrier member and said separating element in a jig;
- casting said protective material on its liquid state on said jig, covering at least a portion of said board, said at least a portion being separated from said at least one contact by said separation element;
- extracting said assembly with said protective layer from said jig after said protective layer has become solid;
- mounting said assembly in said household appliance.

Preferably, the protective material in its liquid state is casted on said jig covering a portion of said board / carrier member, said portion being separated from said at least one contact by said separation element.

Preferably, the jig comprises two half-shells, which advantageously can be fixed to each other for firmly connecting them during the insertion and the subsequent state change of the protective material.

Advantageously, in the inserted state of the board in the jig, a clearance between the jig and the board is provided which allows the protective material in its liquid state to flow through or onto both sides of the board.

The jig preferably comprises a pin which in the inserted state of the board and the separation element enters concentric holes provided in the board and the separation element, preventing undue displacement between the board and the separation element during the casting of the protecting material.

The advantages of the invention are essentially as follows. The separating element allows potting methods for providing a layer on the board even with a board design where the contacts are not surrounded by a cage but are located at an edge or at the periphery of the board. Due to the low pollution degree on the circuit environment, the layout of the electronic board allows saving of space. A separating element built as a frame grants an optimized positioning of connectors and permits a simplification of the envelope design, in which peripheral contacts can be provided on any position of the board periphery. Due to the smaller possible size of the board and the possibility to use edge connectors wherever necessary, costs are saved and the board construction is simplified. A circuit board designed according to the invention provides high reliability and thus increases the lifetime of the household appliance and enhances its value to the customer.

### Brief description of the drawings

Further features and advantages of the present invention shall become clearer from the following detailed description of some of its preferred embodiments, made with reference to the attached schematic drawings and given as an indication and not for limiting purposes.

In particular, the attached drawings are included to provide a further understanding of the invention and are incorporated in and constitute a part of this specification. The drawings together with the description explain the principles of the invention. In the drawings, corresponding characteristics and/or components are identified by the same reference numbers. In these drawings:
FIG. 1 shows a household appliance designed as a front-loading washing machine in a preferred embodiment in an assembled state with a front panel, an inlay and a fixation element in a perspective view;
FIG. 2 shows a separating element in a first perspective view;
FIG. 3 shows the separating element of FIG. 2 in a second perspective view;
FIG. 4 shows the separating element of FIG.2 in a top view;
FIG. 5 shows the separating element of FIG. 2 in a first side view;
FIG. 6 shows the separating element of FIG. 2 in a second side view perpendicular to the side of view of FIG. 5;
FIG. 7 shows an assembly of a control circuit board and the separation element of

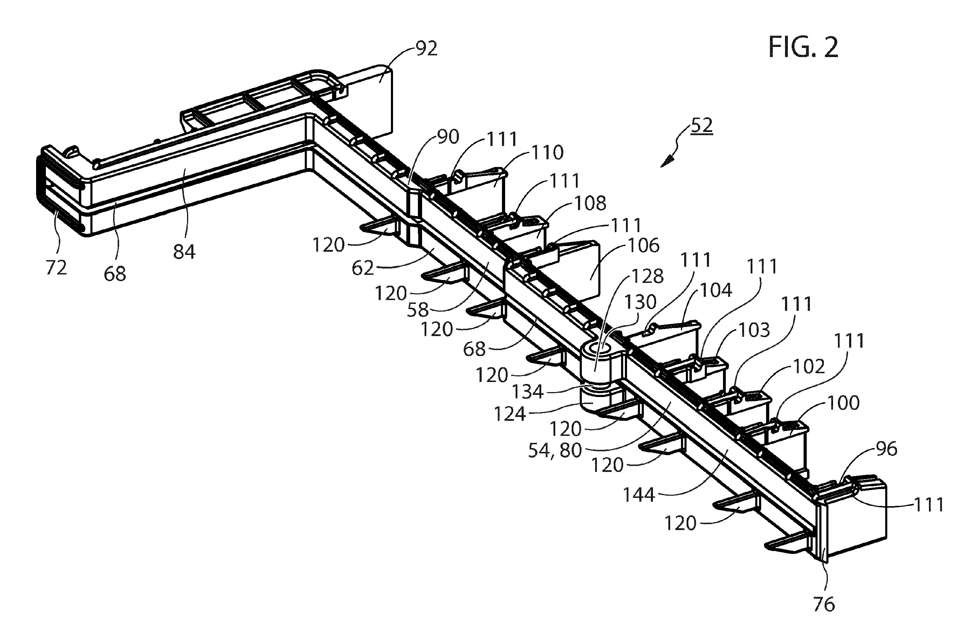

FIG. 2 in a first perspective view;

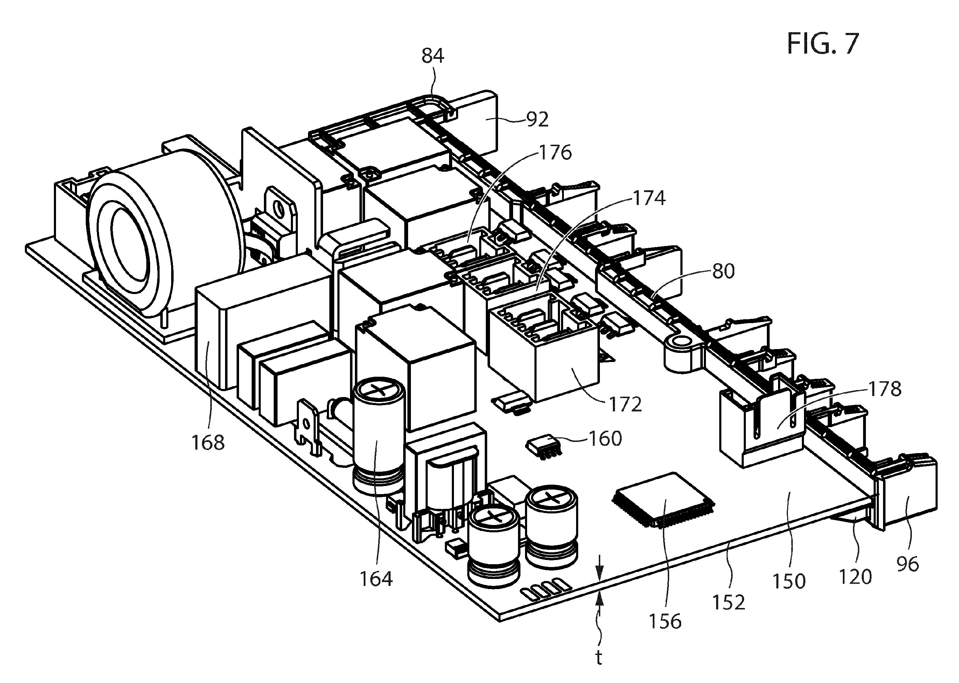

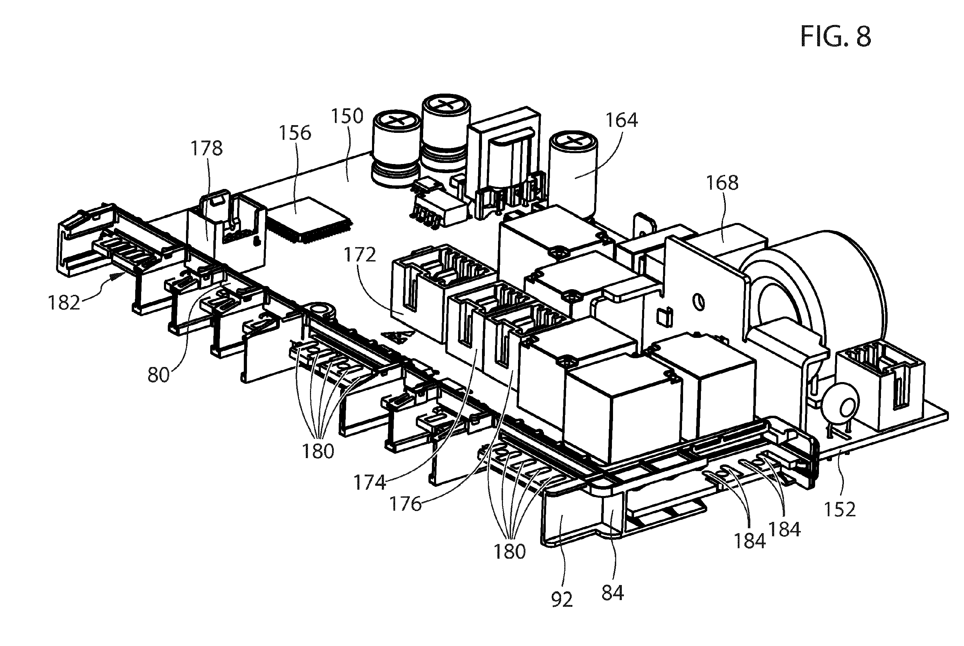

FIG. 8 shows the assembly of FIG. 7 in a second perspective view;

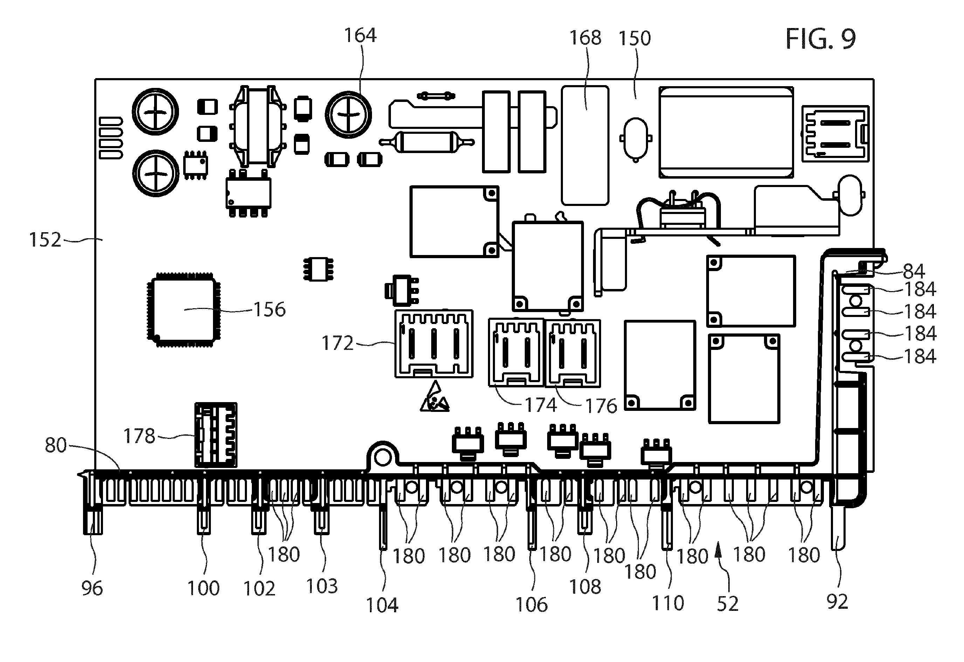

FIG. 9 shows the assembly of FIG. 7 in a top view;

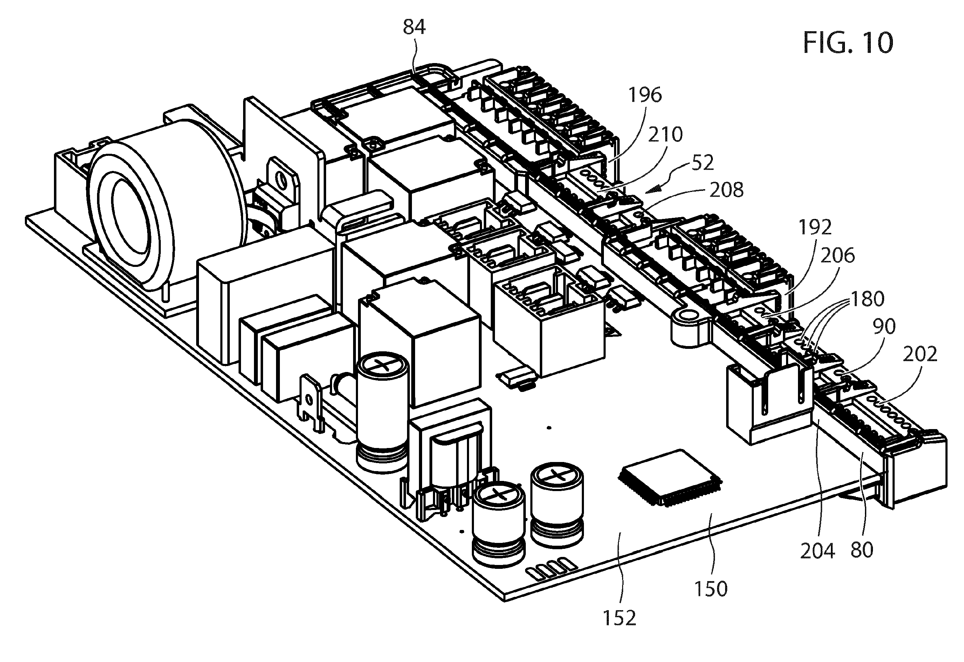

FIG. 10 shows the assembly of FIG.7 with connector elements attached to the separation element in a perspective view;

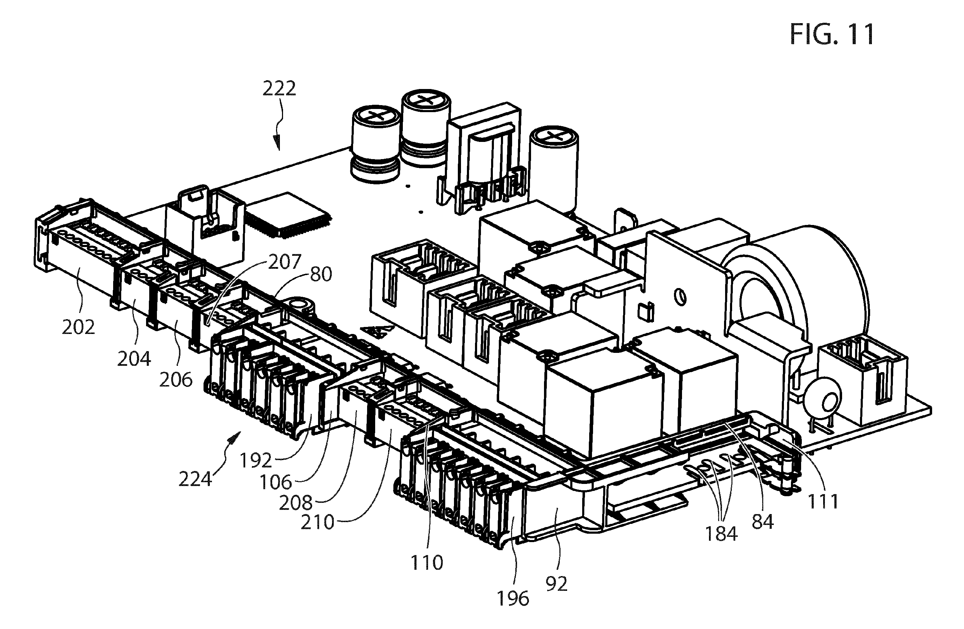

FIG. 11 shows the components of FIG. 10 in another perspective view;

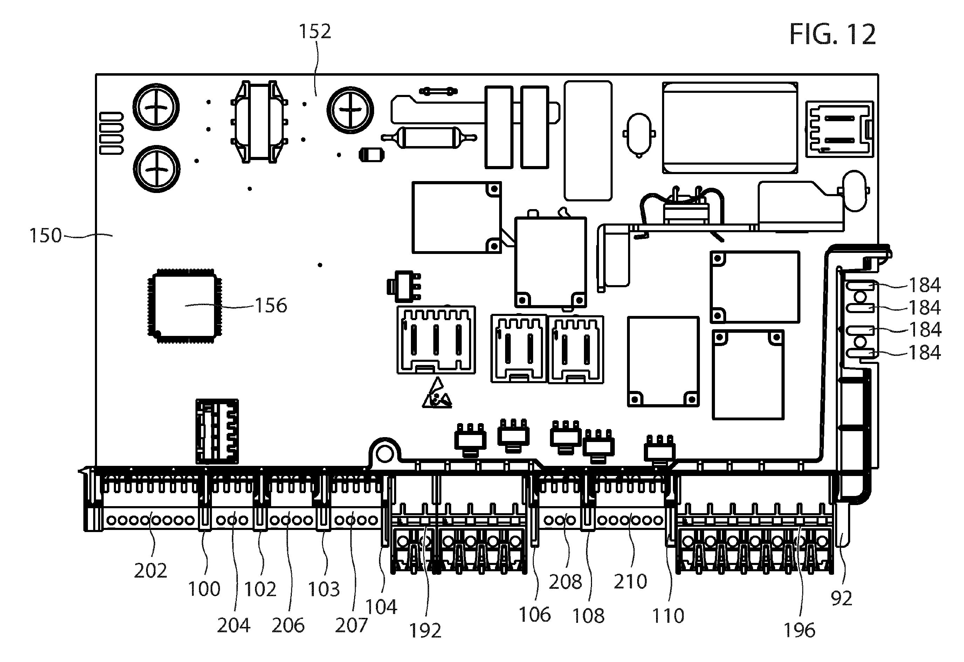

FIG. 12 shows the components of FIG. 10 in a top view:

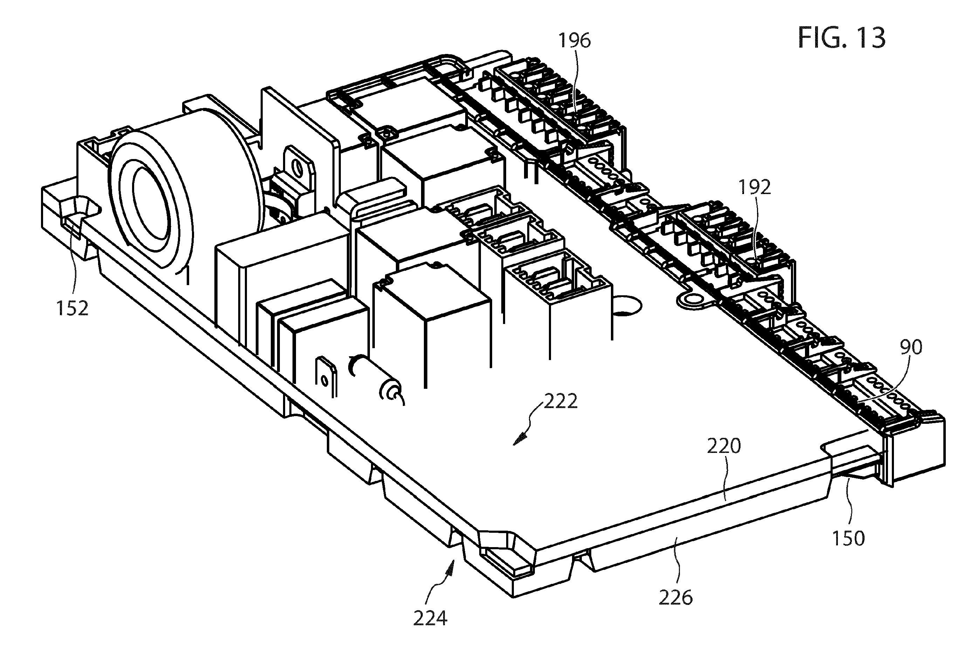

FIG. 13 shows the control circuit board, separation element and connectors according to FIG. 10 with the board having both sides covered with a protective layer in a perspective view;

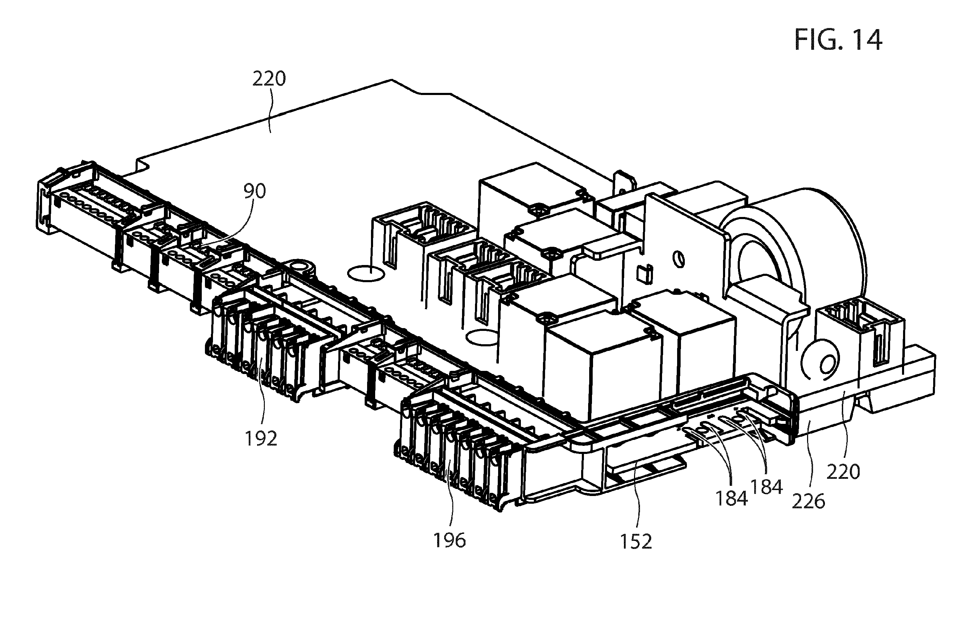

FIG. 14 shows the components of FIG. 13 in another perspective view;

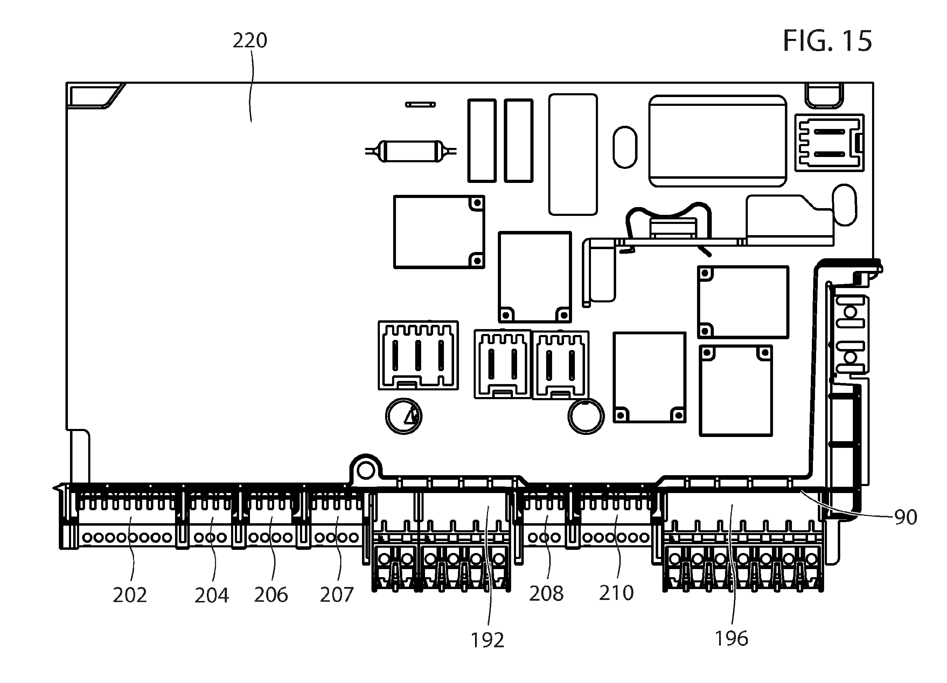

FIG. 15 shows the components of FIG. 13 in a top view;

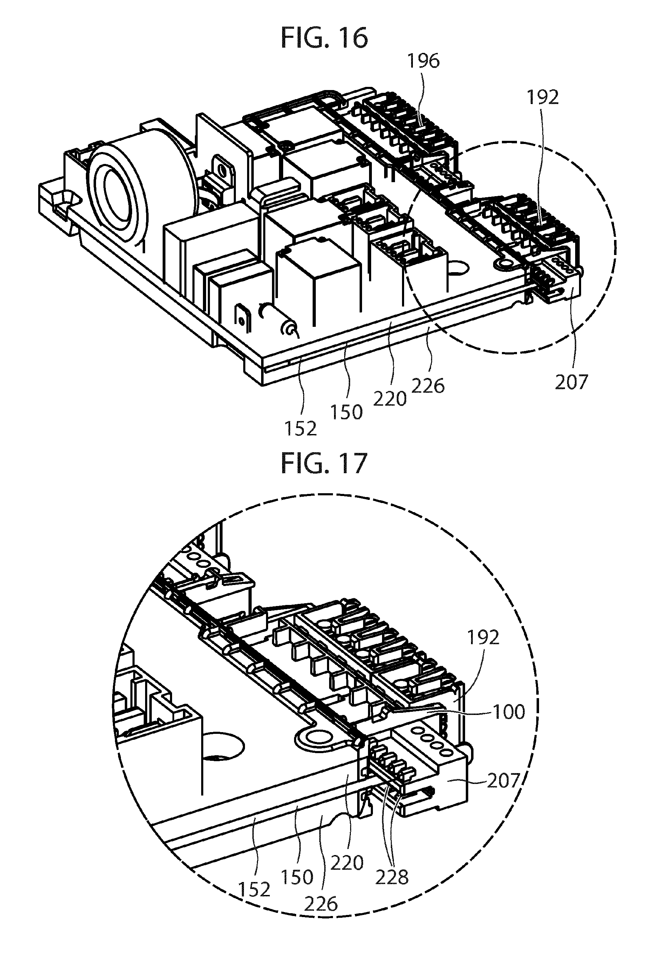

FIG. 16 shows a cut through the components of FIG. 13 in a perspective view with a region encircled;
FIG. 17 shows an enlarged view of the region encircled in FIG. 16;

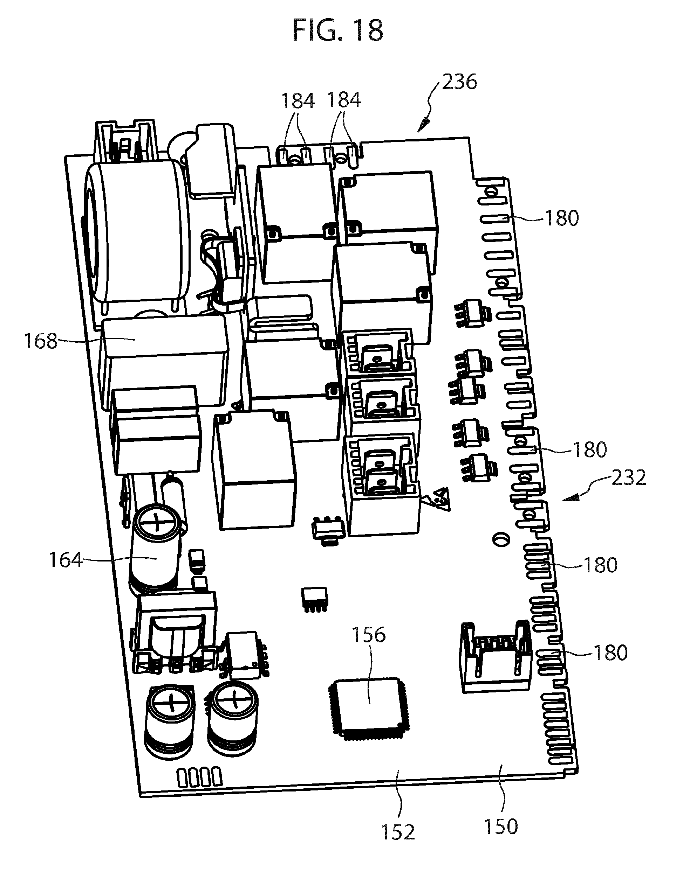

FIGs 18 to 23 illustrate subsequent steps in a method for manufacturing a household appliance.

### Detailed Description of the Invention

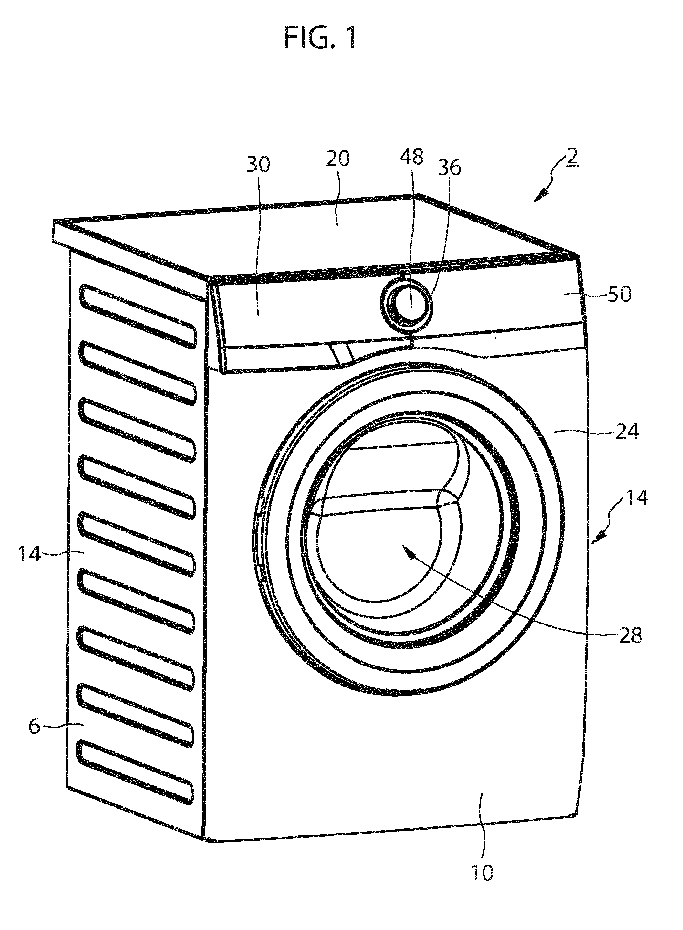

In FIG. 1, a household appliance 2 is shown which is built as a front-loading washing machine and comprises a housing or casing 6 with a preferable parallelepiped shape, the casing 6 comprising a front wall 10, two side walls 14 a rear wall (not shown), and a cover plate 20. Front wall 10 and side walls 14 are preferably part of a cabinet. A front door 24 is provided which can be opened for loading or unloading laundry through an opening 28 preferable provided on the front wall 10 into a washing drum.

Advantageously a washing tub is contained within casing 6, whereby a rotatable and perforated drum is contained by said washing tub. Both washing tub and drum have a substantially cylindrical shape. Advantageously the tub is suspended in a floating manner inside casing 6 by means of a number of coil springs and shock absorbers. The drum is rotated by an electric motor (not shown), which transmits the rotating motion of a motor shaft to the drum by a belt/pulley system. In a different embodiment of the invention, the motor can be directly associated with the shaft of the drum. The tub is preferable connected to casing 6 by means of an elastic bellows or gasket. Alternatively, said laundry appliance can be a dryer (in which case the tub is not provided) or a combined washer and dryer.

The preferred washing machine shown in FIG.1 comprises a front panel 30 with a frontal surface 36 which comprises a hole for insertion of a user interface element or control element which is preferably designed as a combined knob/push button 48 which can be used to control laundry treatment appliance 2 by selecting a washing program and/or a parameter thereof. Knob/push button 48 can thereby allow by rotation to select different parameters and/or washing programs; if it is further or alternatively provided with a push function, preferable allowing additional program selection and / or a switching-on function of the appliance / programs.

Moreover, the user interface element 48 can further or alternatively comprise a display for showing, for example, the chosen and / or available program or parameter and / or status updates thereof and / or errors which occurred; additionally or alternatively, the display can be of the touch-type, allowing the change of programs or display modes through the user touch of the display.

The household appliance 2 shown in FIG. 1 is provided with at least one control circuit board for controlling several of its functions and operational modes. The control circuit board and related components will be discussed in conjunction with the following FIGs.

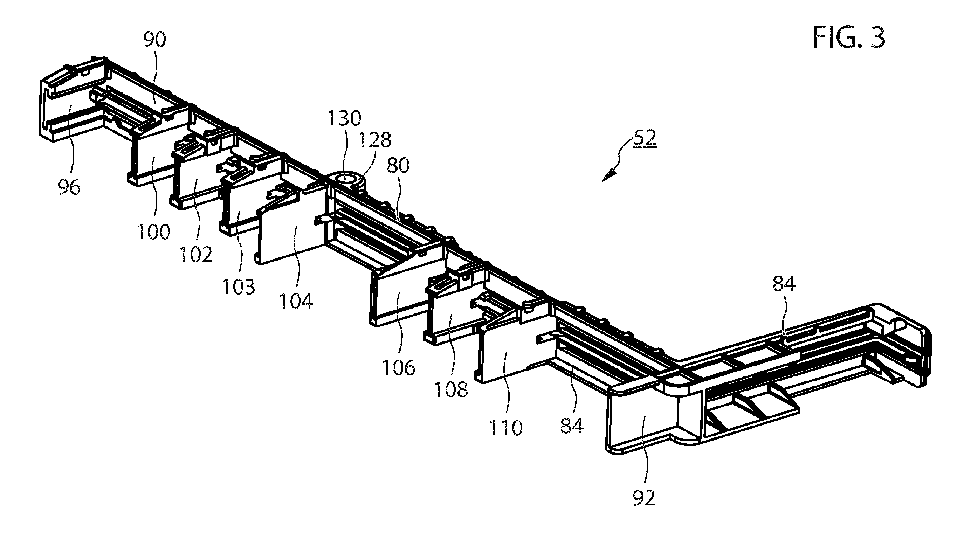

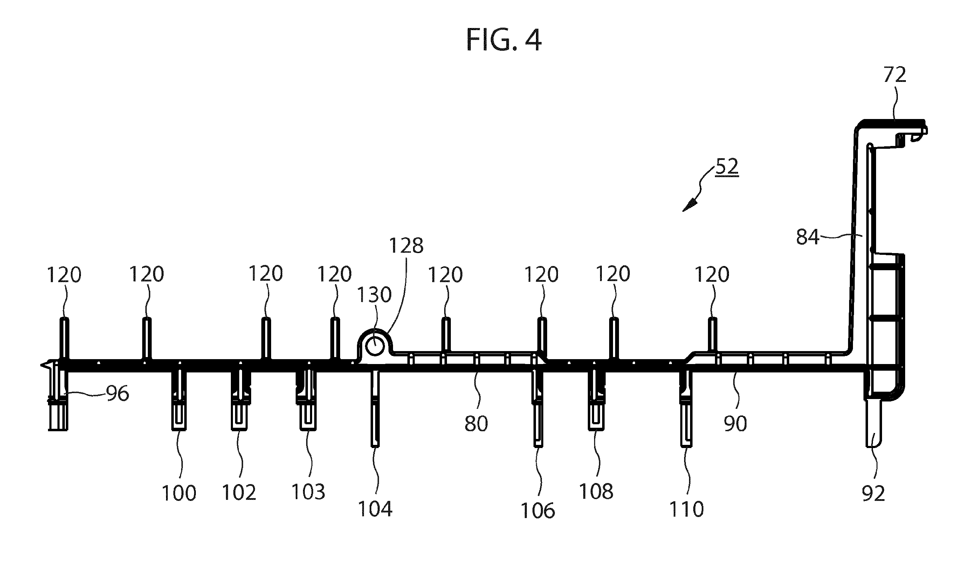

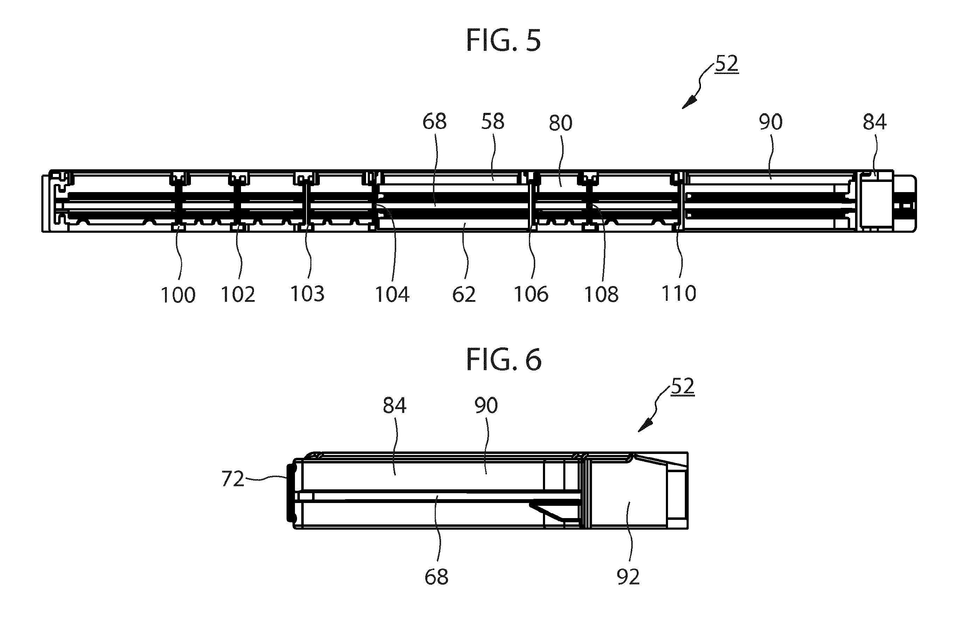

A separating element 52 shown in the FIGs 2, 3, 4, 5, 6, which is provided on the control circuit board of the household appliance comprises a body 54 preferably made of plastic, preferable comprising an upper part 58 and a lower part 62 between which a gap 68 is formed, providing a clearance that preferably essentially corresponds to the thickness of the control circuit board on which separating element 52 is mounted. Upper part 58 and lower part 62 are connected by a connection element 72 which provides them at the desired distance as described above. In the shown embodiment, on an opposite end of separation element 52, a second connection element 76 is provided.

Separation element 52 has an L-shape, comprising a first part 80 and a second part 84 which is inclined with respect to first part 80, whereby in the present preferred embodiment, the inclination corresponds to 90°, that is, first part 80 and second part 84 are oriented perpendicular to each other. Both parts 80, 84 form the gap 68 which can receive the a peripheral or edge part of the control circuit board. The separation element 52 is preferably designed as a frame 90, whereby parts 80, 84 preferably frame two adjacent and perpendicular sides of the control circuit board if assembled on the board.

First part 80 comprises a protruding edge element 92 which is preferably aligned parallel to second part 84. First part 80 also comprises a further protruding edge element 96. The frame 90 comprises partition elements 100, 102, 103, 104, 106, 108, 110 protruding from both parts 80, 84 which in a mounted state on the control circuit board spatially separate groups of peripheral contacts provided on the control circuit board and in conjunction with the protruding edge elements 92 and 96, serve to connect connectors for electrically connecting these contacts.

The edge element 92 and the partition elements 100,102, 104, 106, 108, 110 preferable act as connection elements for connecting upper part 58 and lower part 62.

Frame 90 additionally can comprise elements 120 protruding in a direction opposite to the direction in which partition elements 100-110 protrude from main body part 114. Elements 120 are configured to become embedded / inserted in a protective layer which in a fully assembled state covers the control circuit board at least partially.

According to one preferred embodiment, on one or on both sides of gap 68, sleeve elements 124, 128 are provided which have, respectively, concentric holes 130, 134; moreover, the control circuit board comprises a hole, configured and positioned so that it is concentric with the holes 130, 134 provided on the frame in the assembled state of the latter on the board, allowing the insertion of a pin through said hole and the frame holes 130, 134. This configuration enhances the stability of the assembly of frame 90 and control circuit board.

The control circuit board 150 shown in FIG. 7, preferable comprises a carrier member 152 or carrier element on which functional components are provided such as a central processor 156, a chip, further electrical components 164, 168, as well as connector cages 172, 174, 176, 178. There are further components mounted on the board 150 which are not labelled and which can correspond to standard components such as circuit tracks suitable to electrically connect the several components and the contact according to a determined circuit sequence / logic. Frame 90 is mounted on the carrier member 152. In this mounted or assembled state, a peripheral part of the carrier member 152 is preferable received by the gap 68 or clearance which is provided between upper part 58 and lower part 62. This is possible since the thickness of the carrier member 152 essentially corresponds to the size of the gap 68 between upper part 58 and lower part 62.

As can be seen in FIG. 8, the control circuit board 150 preferably comprises several contacts 180 which are directly provided on the periphery 182 of board 150 and preferable of carrier member 152. Contacts 180 are not provided in connector cages but are arranged directly on the surface of carrier member 152.

The frame 90 in its mounted position is provided on the board in such a way that it spatially defines the board region with the peripheral contacts and the region of the board on which the functional components are provided.

The frame 90 / separation element 52 acts as a barrier between the periphery of board 150 where contacts 180 are provided and the part of the board with functional components are placed in such a way that when potting a protective layer on board 150 on the side with the functional components, the potting material is hindered by frame 90 to flow onto the side with contacts 180 and thus to cover them. In this way, a potting procedure for the board can be employed even with peripheral contacts which are not protected by a connector cage. Additionally, the jig used for the potting procedure does not need a complicated design since the functionality to hinder the layer material to cover the contacts is solved by frame 90.

Due to the preferred L-shape design of frame 90, the second part 84 of frame 84 spatially separates the part of the board 150 with functional components from another group of contacts 184 on a side of board 150 adjacent to the side with contacts 180. The invention is not limited to frames 90 with an L-shape. Frame 90 could, for instance, have a U-shape, allowing having peripheral contacts on three adjacent sides of board 150. Also, frame 90 could only frame one side or even all four sides, at least partially.

As can be seen in the top view shown in FIG. 9, partition elements 100-108 preferably spatially separate groups of connectors 180, i.e., between partition elements 100 and 102, three contacts 180 are preferably provided. These groups are preferably chosen with respect to the various connectors that can be connected to board 150. As can also be seen, frame 90 is mounted on board 150 in such a way that contacts 180, 184 are accessible by connectors and are not covered by parts of frame 90.

FIGs 10, 11 and 12 shows two connectors 192, 196 being attached to frame 90. Connectors 192, 196 respectively allow connection of electric components to the board 150 preferable through electric wirings. The connectors 192, 196 therefore, respectively, provide contacting elements which respectively build an electric contact to a corresponding contact 180 on board 150. These contacting elements can be designed as spring contacts which in the mounted state of connector 192, 196 are pressed against contacts 180. The connectors 192, 196, are attached, respectively, to partition elements 100-110, preferably through snap engagement with sharp-edges 111 provided on said partition elements. Further connector elements 202, 204, 206, 207, 208, 210 are attached to frame 90 which allow the electric connection of the contacts 180 on board 150 to other parts of the laundry appliance as needed. Contacts 184 are not electrically connected to a connector in the FIGs shown. A connector can also be attached to frame 90 in order to contact these contacts.

In the present preferred embodiment, board 150 comprises peripheral contacts 180 on both the upper or top side 222 and on the opposite lower or bottom side 224, even if they are only shown on the upper side in the FIGs The invention comprises also the embodiment where only on one side of board 150 contacts are provided.

In FIGs 13, 14, 15, board 150 is shown being covered on its top side 222 with a first protective layer 220 and on its bottom side 224 with a second protective layer 226. Both protective layers 220, 226 are created by potting and are essentially made of silicon. On the top side, protective layer 220 completely covers, for instance, central processor 156 and circuit tracks on carrier member 152, while other functional components stick out of protective layer 220. In this way, the critical parts of board 150 are protected which, when getting in contact with dust, water, vapor, steam, fluff or other contaminating particles, can possibly lead to short circuits and to damage of the control circuit board 150 and electrically connected components.

On the bottom side of board 150, protective layer 226 preferably covers circuit tracks. As can be seen very clearly in FIG. 15, protective layer 220 is spatially separated from connectors 192, 196 and from connectors 202-210 by frame 90. Frame 90 separates protective layer 220 also from contacts 180, 184 provided at the periphery of carrier member 152. Equivalently, this holds true for protective layer 226 on the bottom side of board 150. Elements 120 are preferably partially embedded in protective layer 226, leading to an enhanced stability of the assembly.

A selected region of board 150, frame 90 and connector 196 is shown in a cut shown in FIG. 16 and is displayed in an enlarged view in FIG. 17. In both FIGs, the sandwich-type structure of protective layers 220, 226 and carrier member 152 which is sandwiched between layers 220, 226 is clearly visible. Connector 207 comprises connection elements 228 which are in electrical contact with contacts 180 on board 150.

A method for assembling a household appliance 2 in a preferred embodiment is illustrated in conjunction with FIGs 18 to 22. The household appliance 2 comprises a control circuit board 150 shown in FIG. 18 preferably with a carrier member 152 on which functional components 156, 164, 168, and / or circuit tracks and / or others not labelled components are mounted. At the periphery of one side or edge 232 of carrier member 152, contacts 180 are provided. At the periphery of an adjacent side or edge 236, further contacts 184 are provided. Contacts 180, 184 are directly provided on board 150 / carrier member 152 and are not enclosed by a connection cage or similar means.

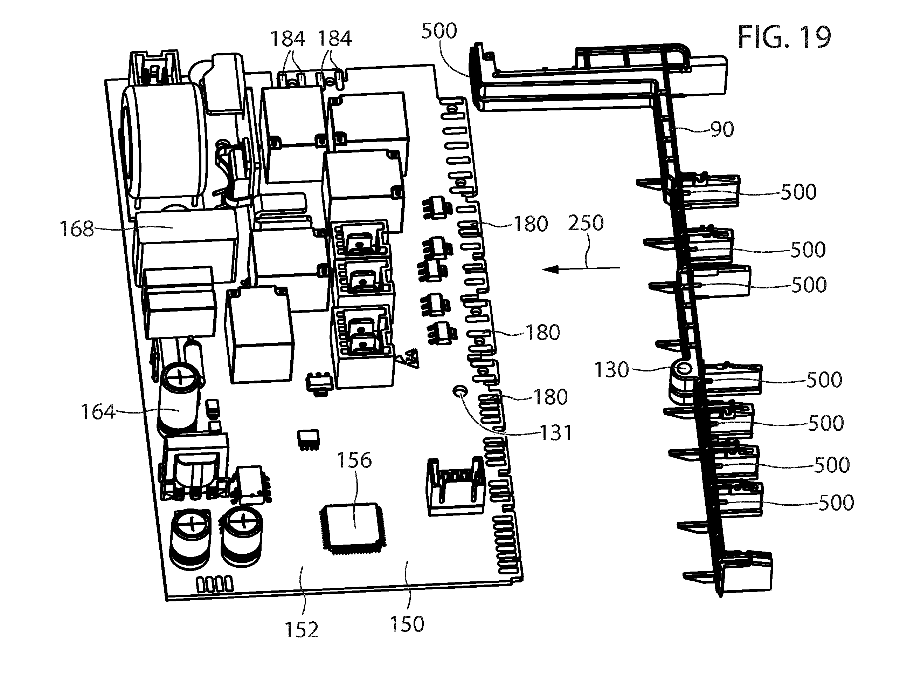

A frame 90, which has been described in connection with the previous FIGs and which is shown in FIG. 19 together with board 150, acts as a separation element between contacts 180, 184 and protective layers to be applied to board 150 and is mounted on board 150, as indicated by an arrow 250. The resulting clearance between the upper part 58 and the lower part 62 allows the partial insertion of the carrier member peripheral edge until to contact the clearance end 500 provided on each partition element 100-110 of the frame 52. The corresponding final position of the frame with respect to the board / carrier element allows the division of the contact 180 from the portion resulting on the other side of the frame; alternatively, the frame and the corresponding clearance end can be configured to allow the partial division of the contact between the two sides of said frame; according to this alternative embodiment, only the portion of the contact of the frame side where the protective layer is not present will act as a contact for the external electrical connection.

Preferably, the separating element 52 in its mounted position is in contact with said protective layer 220, 226.

Alternatively, the frame can be composed of a one- piece only, suitable to be connected through known connection means (screws, glue, snap means) on one side only of the board /carrier member.

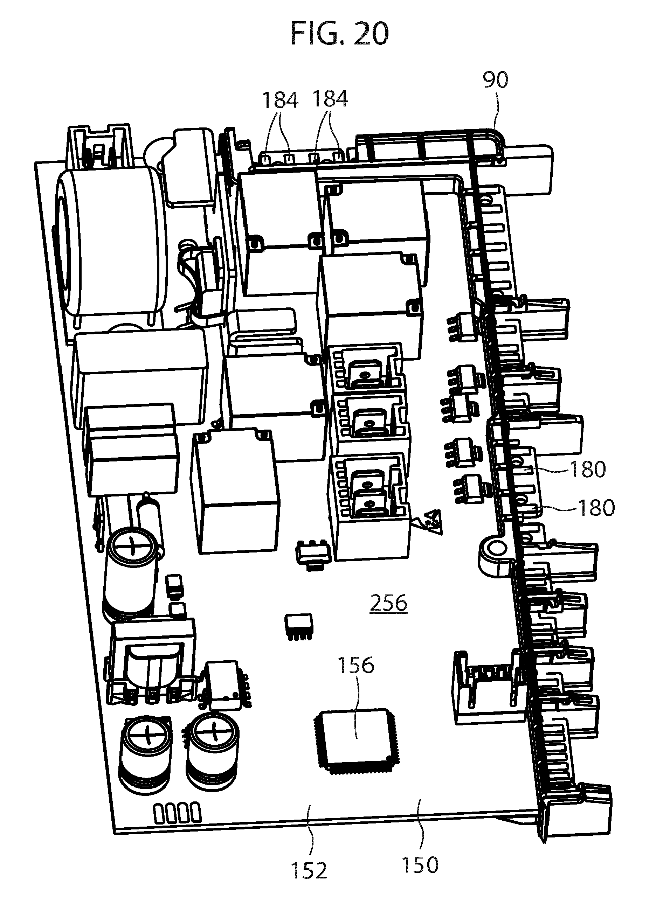

Board 150 and frame 90 in a mounted state are displayed in FIG. 20. Frame 90 builds a spatial barrier between a region 256 of board 150 which is to be protected by a protective layer and contacts 180, 184.

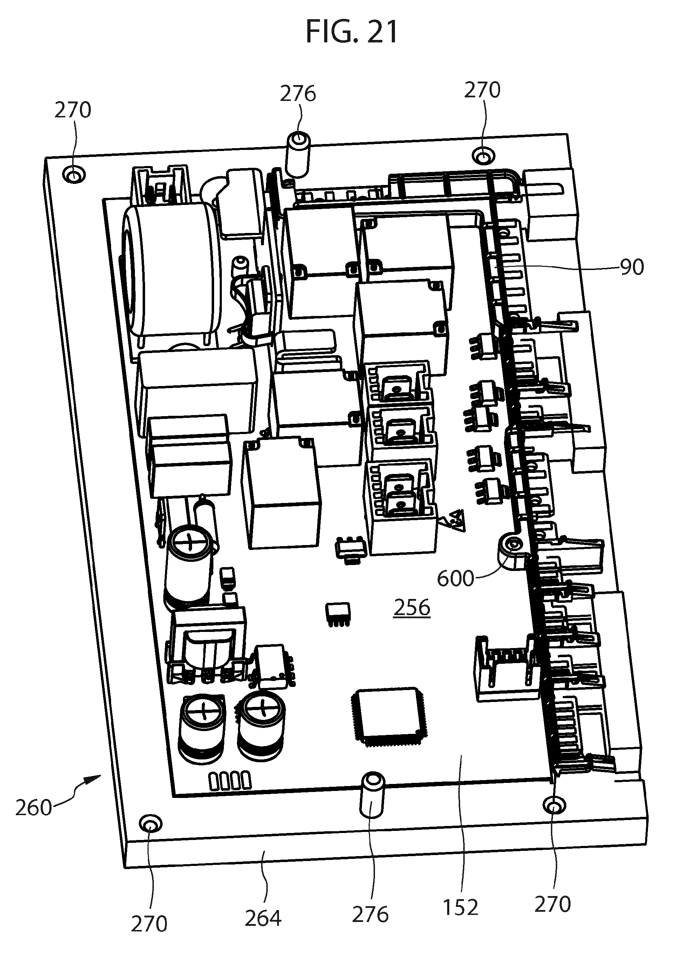

Board 150 with mounted frame 90 is inserted into a jig 260, as illustrated in FIG. 21. Before the insertion, board 150 is preferably heated in order to drive off residual moisture. This is preferably conducted by putting it into an oven at 60° C for 1-2 hours.

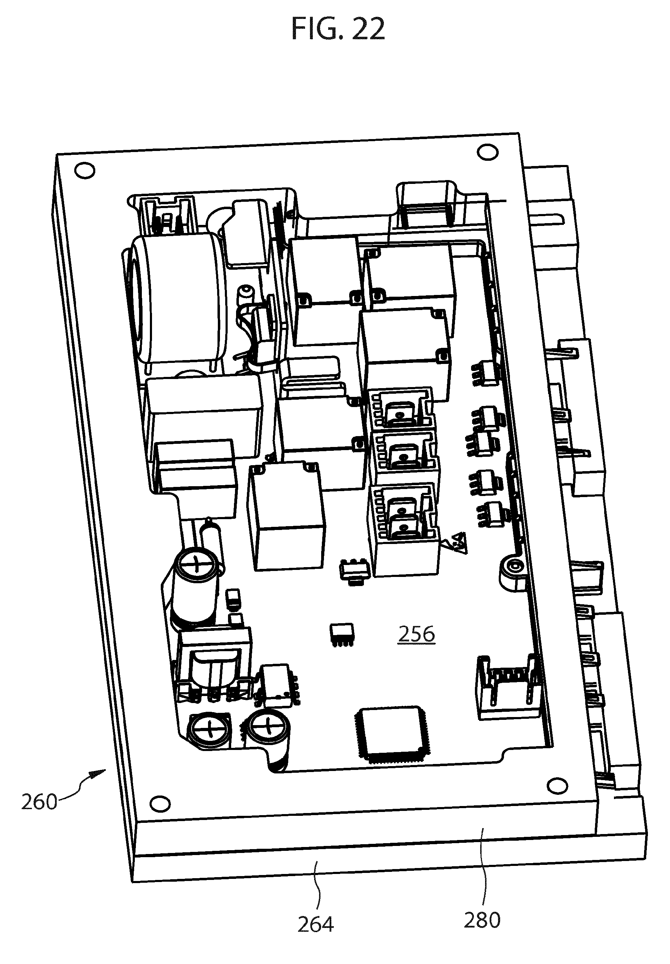

Jig 260 comprises a lower half-shell 264 with a rectangular shape into which the assembly is inserted. Lower half-shell 264 is designed and configured in such a way that the assembly of board 150 and frame 90 is seated firmly and is not prone to movements during a subsequent potting procedure. Lower half-shell 264 comprises four holes 270 located in its corners and two pegs 276 located between two adjacent holes 370 and arranged on opposite sides of lower half-shell 264 for connection with an upper half-shell 280 of jig 260 shown in FIG. 22. In the inserted state of board 150 / carrier member 152 in jig 260, a pin 600 provided on lower half shell 264 of jig 260 is positioned in holes 130, 134 which are provided in sleeve elements 124, 128 of the frame 90 and in a hole provided on board 150. These holes are arranged concentrically and are aligned by pin 600. During the casting of the protective material, due to this configuration an unwanted displacement between frame 90 and board 150 is prevented. In other embodiments, further groups of pins and corresponding holes in frame 90 and board 150 / carrier member 152 can be provided.

A protective material designed to form the protective layer, which in the present preferred embodiment is silicon, is initially in a liquid state. The protective material is preferably mixed from two components with different viscosities in order to obtain a material with the desired viscosity in between these two viscosities. The two material components, labelled henceforth A and B, can preferably have the following properties at a temperature of 23°C and a humidity of 70% :
Component A:
   Density: 1,10 g/cm³; viscosity: 850 mpa•s
Component B:
   Density: 0,98 g/cm³; viscosity: 600 mpa•s

The mixture is preferably performed by weighing a certain amount of component A, the proportionally adding component B, then mixing them in a mixing container until the mixture has reached a homogeneous state. The resulting mixture is preferably deareated, most advantageously by vacuum deaerating the mixture materials.

The protective material, in liquid form, is then cast on jig 260 and thereby poured on the board 150, entering in contact with the jig edges and the internal edge of the frame, allowing it to cover portion or region 256 of board 150. In the inserted state of board 150 in jig 260, a clearance between jig 260, i.e. between its respective half-shell 264, 280 and board 150 is provided which allows the protective material on its liquid state to flow through both sides of board 150. Frame 90 prevents contacts 180, 184 to get covered by the protective material during the process of the protective material entering jig 260 and distributing itself in jig 260. The jig therefor can have a relatively simple shape and does not need to comprise barrier elements which hinder the protective material to cover the peripheral contacts in its liquid state.

After it has filled jig 260 and has stopped moving / flowing, the protective material is then heated and then cured. This heating is preferably performed at a temperature of 45 °C. Curing is preferably performed for 45-60 minutes.

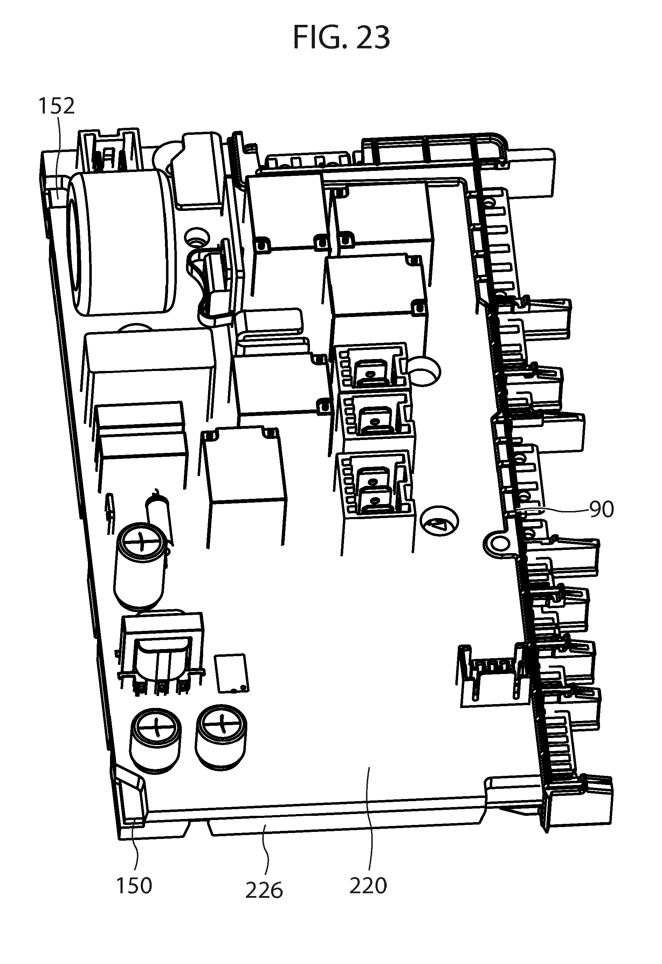

Subsequently, board 150 covered with protective layers 220, 260 in solid state on both of its sides and with frame 90 mounted, see FIG. 23 is extracted from jig 260 and mounted in household appliance 2.

The invention thus conceived can be subjected to numerous modifications and variants all falling within the scope of the inventive concept.

In addition, all details can be replaced by other technically equivalent elements. In practice, all the materials used, as well as the shapes and contingent dimensions, may vary depending on the requirements without departing from the scope of protection of the claims.

## Claims

1. Household appliance (2) with at least one control circuit board (150), said control circuit board (150) comprising at least one contact (180, 184) provided at the periphery (182) of said board (150), and further comprising a protective layer (220, 226), said layer (220, 226) covering said board (150) at least partially,
**characterized in**
**that** a separating element (52) is provided on said board (150), said separating element (52) being configured and positioned to separate said at least one contact (180, 184) from said protective layer (220, 226).

2. Household appliance (2) according to claim 1, wherein said control circuit board (150) comprises a carrier member (152) where functional components (156, 164, 168) and / or circuit tracks are provided, wherein said at least one contact (180, 184) is directly provided at the periphery (182) of said carrier member (152) and the protective layer (220, 226) covers said carrier member (152) at least partially, and wherein said separating element (52) is provided on said carrier member (152), configured and positioned to separate said at least one contact (180, 184) from said protective layer (222, 226).

3. Household appliance (2) according to claim 1 or 2, wherein said separating element (52) in its mounted position is in contact with said protective layer (220, 226).

4. Household appliance (2) according to one of the claims 1 to 3, wherein said separating element (52) comprises an upper part (58) and a lower part (62), said parts being connected by at least one connection element (72, 76) by which said parts (58, 62) are distanced by a distance essentially corresponding to the thickness of said control circuit board (150) / carrier member (152).

5. Household appliance (2) according to one of the claims 1 to 4, wherein said separation element (52) comprises at least one element (120) configured to be embedded in or inserted into said protective layer (220, 226).

6. Household appliance (2) according to one of the claims 1 to 5, wherein said board (150) / carrier member (152) comprises at least one opening, and whereby said separation element (52) comprises at least one opening (130) which in a mounted position of said separation element (52) is concentric with said opening on said board (150) / carrier member (152).

7. Household appliance (2) according to one of the claims 1 to 6, wherein said separation element (52) comprises connection means (100-111), said means being configured to allow the assembly of at least one connector (192, 196, 202-210).

8. Household appliance(2) according to one of the claims 1 to 7, wherein said separation element (52) has an L-shape, comprising a first part (80) and a second part (84) which is inclined with respect to said first part (80).

9. Household appliance (2) according to one of the claims 1 to 8, wherein said protective layer (220, 226) is essentially made of a protective material that changes its state from a liquid state to a solid state.

10. Household appliance (2) according to claim 9, wherein said protective material is in a liquid state and reaches a solid state after the polymerization.

11. Household appliance (2) according to one of the claims 1 to 10, wherein said protective material is essentially silicon.

12. Method for assembling a household appliance (2), said household appliance (2) comprising at least a control circuit board (150) comprising at least one contact (180, 184) provided at the periphery (182) of said board (150), said method comprising the steps of:
• mounting a separation element (52) on said board (150);
• inserting the assembly of said board (150) and said separating element (52) in a jig (260);
• casting the protective material on its liquid state on said jig (260), covering at least a portion (256) of said board (150), said at least a portion being separated from said at least one contact (180, 184) by said separation element (52);
• extracting said assembly with said protective layer (220, 226) from said jig (260) after said protective layer has become solid;
• mounting said assembly in said household appliance (2).

13. Method according to claim 12, wherein said control circuit board (150) comprises a carrier member (152) where functional components (156, 164, 168) and / or circuit tracks are provided, wherein said at least a contact (180, 184) is directly provided at the periphery (182) of the carrier member (152), said method comprising the steps of:
• mounting a separation element (52) on said carrier member (152);
• inserting the assembly of said carrier member (150) and said separating element (52) in a jig (260);
• casting the protective material on its liquid state on said jig (260), covering at least a portion (256) of said board (150), said at least a portion being separated from said at least one contact (180, 184) by said separation element (52);
• extracting said assembly with said protective layer (220, 226) from said jig (260) after said protective layer has become solid;
• mounting said assembly in said household appliance (2).

14. Method according to claim 12 or 13, wherein the protective material in its liquid state is casted on said jig (260) covering a portion of said board / carrier member, said portion being separated from said at least one contact (180, 184) by said separation element (52).

15. Method according to one of the claims 12 to 14, wherein in the inserted state of said board (150) in said jig (260), a clearance between said jig (260) and said board (150) is provided which allows the protective material in its liquid state to flow through both sides (222, 224) of said board (150).
